# FASCICULE DE BREVET EUROPEEN

(11) **EP 1 039 791 B1**
(45) Date de publication et mention de la délivrance du brevet: **06.10.2004**
(21) Numéro de dépôt: 00106326.2
(22) Date de dépôt: 23.03.2000
(51) Int. Cl.: H05K 5/02

(54) **Boîtier électronique**
Elektronikgehäuse
Electronic casing

(30) Priorité: 26.03.1999 FR 9903789
(43) Date de publication de la demande: 27.09.2000
(73) Titulaire: Siemens VDO Automotive S.A.S., 31036 Toulouse Cédex 01 (FR)
(72) Inventeur: Hellemans, Roel, 31170 Tournefeuille (FR)
(74) Mandataire: Berg, Peter, Dipl.-Ing.

(56) Documents cités:
- DE-A- 2 031 734
- DE-A- 19 800 453
- DE-U- 8 137 939
- US-A- 4 181 386
- US-A- 4 749 370

## Description

L'invention est du domaine des boîtiers électroniques. Elle concerne plus particulièrement un boîtier dans lequel une connexion doit être assurée entre un câble plat et un circuit imprimé.

Le plus souvent, la connexion d'un câble plat sur un circuit imprimé est réalisée en utilisant des connecteurs sertis, par exemple comportant des broches traversant le circuit imprimé, ce qui représente une solution complexe et chère, donc peu satisfaisante.

Par ailleurs, dans le cas de câbles plat connectés à un circuit imprimé et installés par exemple dans un environnement de montage agressif, des efforts de traction significatifs peuvent être exercés entre le câble plat et le boîtier, et il est clair que ces tractions ne doivent pas aboutir à déconnecter le câble plat du circuit imprimé. Une résistance de la connexion à la traction est donc indispensable, un arrachement extérieur au boîtier, bien visible, étant préférable à un dommage interne au boîtier, non détectable visuellement; (voir DE-A-2 031 734).

La présente invention propose un boîtier de connexion par contact direct entre un câble plat et un circuit imprimé, présentant une grande simplicité et une économie en terme de coût de fabrication.

La capacité à résister à un effort de traction du câble plat sans transmission d'effort au niveau de la connexion est un second objectif de l'invention.

Suivant l'invention, le boîtier électronique du type comportant un socle et un couvercle, ledit boîtier étant adapté pour loger à son intérieur au moins un circuit imprimé en connexion électrique avec un câble plat, traversant le boîtier et s'étendant à l'extérieur de celui-ci, le boîtier comporte un moyen de blocage en translation du câble plat et est caractérisé en ce qu'il comporte des moyens de mise en pression d'une zone dénudée du câble plat sur une zone de contact du circuit imprimé, et en ce que le blocage en translation et la connexion électrique sont réalisés de manière simultanée lors de l'emboîtement du couvercle sur le socle.

On comprend que ces moyens permettent bien à la fois d'assurer une connexion électrique entre les conducteurs du câble plat et une zone prédéterminée du circuit imprimé par contact direct, et, d'autre part, de conserver une résistance à la traction autant que possible équivalente à la résistance fournie par des connecteurs sertis.

La description et les dessins qui suivent permettront de mieux comprendre les buts et avantages de l'invention. Il est clair que cette description n'est donnée qu'à titre d'exemple, et n'a pas de caractère limitatif.

Dans les dessins :
- la figure 1 représente une vue en coupe de côté, un boîtier comportant un dispositif de connexion selon l'invention;
- la figure 2 représente une vue élargie d'un détail de la figure 1;
- les figures 3A à 3C illustrent l'assemblage du câble plat sur un circuit imprimé dans un boîtier selon l'invention.

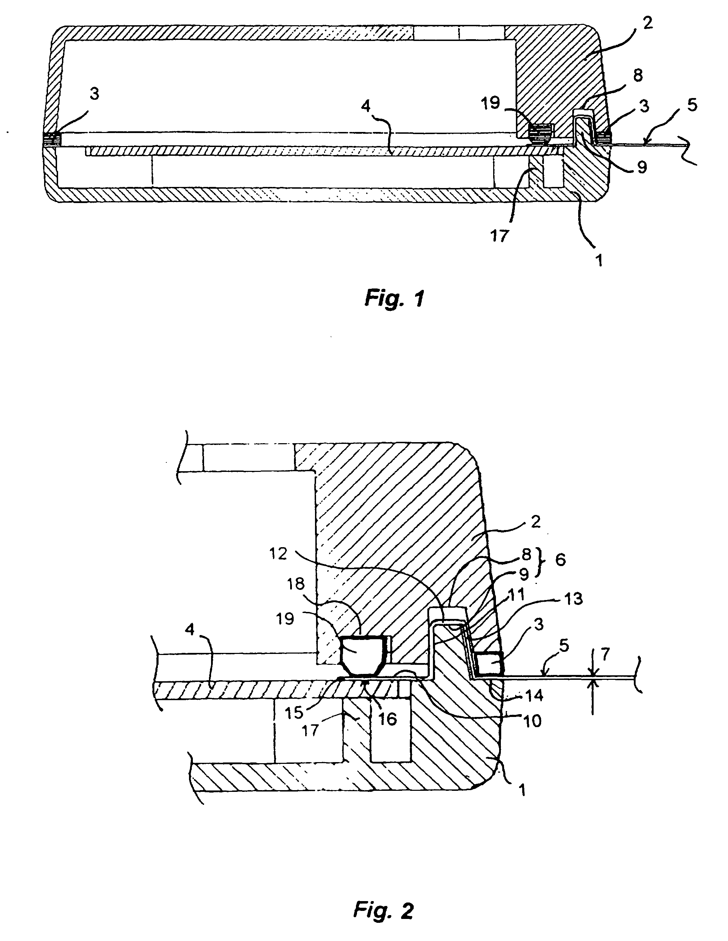

La figure 1 montre un boîtier selon l'invention. Ce boîtier est principalement constitué d'un socle 1 et d'un couvercle 2, de forme extérieure et de matériau classiques, séparés par un joint d'étanchéité 3 disposé à la périphérie du boîtier, et assemblés par plusieurs vis (non représentées).

Le boîtier héberge un circuit imprimé 4 de type PCB (Printed Circuit Board), solidarisé au socle 1 du boîtier par un moyen également classique. Dans l'exemple décrit ici à titre non limitatif, le circuit imprimé 4 et le boîtier sont de forme rectangulaire.

Dans le but de permettre l'entrée d'un câble plat 5 à connecter sur le circuit imprimé 4, le boîtier comporte également, dans une de ses parois latérales, un moyen de blocage 6 (figure 2) entre le socle 1 et le couvercle 2 du boîtier.

Le câble plat 5 dont il est question est du type comportant une nappe de conducteurs sensiblement parallèles, réalisés en cuivre ou aluminium par exemple, et pris entre deux couches de matière plastique d'enrobage de type polyester, polyimide, polyamide etc.

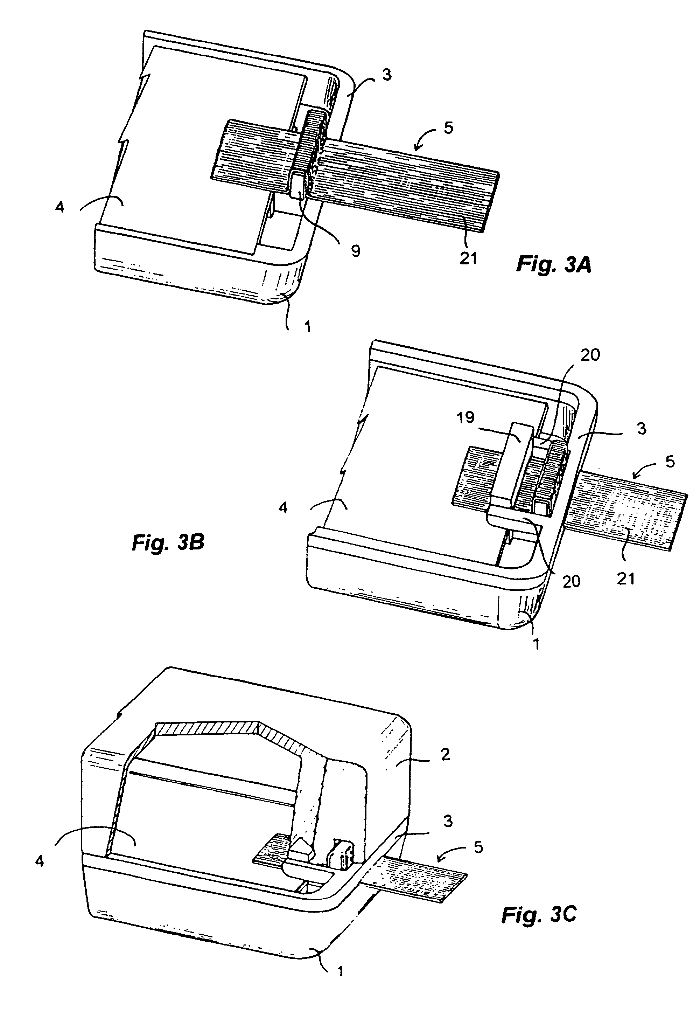

Un tel câble plat 5, comporte typiquement de trois à vingt conducteurs 21 (figure 3), avec une largeur totale de bande de quelques centimètres et une épaisseur 7 de 0,3 mm.

Les conducteurs 21 sont préférentiellement eux-mêmes plats, en étant par exemple formés de feuillards très minces. Ils peuvent cependant être des fils ronds, laminés localement à l'endroit de la connexion prévue sur le circuit imprimé, ou résulter d'un dépôt métallique sur l'une des feuilles de plastique.

On utilisera dans la suite de la description les termes de direction verticale Z pour désigner une direction perpendiculaire au plan du circuit imprimé 4, et de direction horizontale X, pour désigner la direction du câble plat 5, dans le plan du circuit imprimé 4.

Le moyen de blocage 6 ménagé entre le socle 1 et le couvercle 2 du boîtier est réalisé par création d'un évidement trapézoïdal en creux 8 dans le couvercle 2 du boîtier, disposée au regard d'une saillie trapézoïdale 9 présentant un angle de 90°, de forme correspondante sur le socle 1 du boîtier.

Le profil du moyen de blocage 6 comporte ainsi, de l'intérieur du boîtier vers l'extérieur :
- une première zone 10 de direction horizontale (sensiblement parallèle au plan du circuit imprimé),
- une zone de serrage 11 de direction verticale (sensiblement perpendiculaire au plan du circuit imprimé),
- une seconde zone horizontale 12,
- une zone oblique 13,
- une troisième zone horizontale 14.

On a bien formé ici un passage en chicane, apte à créer un blocage au niveau du câble en cas de traction sur celui-ci dans la direction horizontale.

On notera que la câble plat 5 est préformé selon un angle de 90° avant sa mise en place entre l'évidement 18 et la saillie 9. Ce préformage du câble plat 5 avant assemblage assure un positionnement correct des conducteurs 21 sur la zone de contact 16.

La zone de serrage 11 est réalisée, dans le socle 1 et le couvercle 2, de manière à présenter une largeur sensiblement égale à l'épaisseur 7 du câble plat 5. De cette manière, on créé effectivement lors du montage du câble plat 5 entre le socle 1 et le couvercle 2. un pincement léger au niveau de la zone de serrage 11, qui empêche le glissement du câble plat 5 en cas de traction horizontale exercée sur ce câble plat 5. Il est à noter que le câble plat 5 est serré, mais non comprimé au niveau de la zone de serrage, pour éviter de détériorer des conducteurs.

La transition entre la première zone horizontale 10 et la zone de serrage 1 1 est sensiblement à angle droit.

Les transitions (changement de direction) entres les différentes zones du moyen de blocage 6 ont chacune un rayon de courbure supérieur à l'épaisseur 7 du câble plat 5, de manière à éviter un pliage dommageable aux conducteurs 21 dudit câble plat 5.

On note ici qu'un jeu est laissé au câble plat 5 au niveau de la zone oblique 13, pour des raisons de commodité d'assemblage.

Le câble plat 5 a son extrémité 15 disposée, à l'intérieur du boîtier, au dessus d'une zone dite zone de contact 16 sur la face supérieure du circuit imprimé 4. La zone de contact 16 comporte par exemple des surfaces conductrices (plots) de 1,5 x 1,5 millimètre, au regard de chaque conducteur 21 du câble plat 5. Le contact est de type classique, par exemple Etain / Etain, ou Or Etain, Or / Cuivre, Or / Nickel, Or / aluminium nickelé.

L'extrémité 15 du câble plat 5 est préalablement dénudée (sur une de ses faces seulement, pour assurer le maintien du pas entre les conducteurs 21), que ce soit par procédé laser ou par dissolution locale de la matière plastique enrobant les conducteurs 21, de manière à permettre un contact électrique entre les conducteurs 21 du câble plat 5 et les surfaces conductrices de la zone de contact 16 du circuit imprimé 4.

Le socle 1 du boîtier comporte un renfort 17 sensiblement vertical, faisant saillie à partir du fond du socle 1, et adapté à venir sous et au contact de la face inférieure du circuit imprimé 4 lorsque celui-ci est placé dans le boîtier. Ce renfort 17 sert d'élément de contre-pression lorsque le câble plat 5 est comprimé sur le circuit imprimé 4.

Le couvercle 2 comporte quant à lui, au dessus de la zone de contact 16, un évidement de section rectangulaire 18.

Un joint élastique 19 est disposé dans cet évidement, comprimé entre le couvercle 2 et le câble plat 5 au dessus de la zone de contact 16. Ce joint élastique 19 comporte à sa partie inférieure un dièdre arrondi (légèrement écrasé lors d'un appui sur le joint élastique 19), ce qui permet comme on le comprend d'augmenter la pression exercée sur le câble plat 5 au niveau de la zone de contact 16, puisque la surface de contact est réduite.

Le joint élastique 19 est avantageusement réalisé d'un seul tenant avec le joint d'étanchéité 3 (par exemple par moulage), en étant relié à celui-ci par deux pattes 20 de liaison latérales (figure 3B).

Il est clair que le renfort 17 et le joint élastique 19 coopèrent l'un avec l'autre pour la constitution de moyens de mise en pression du câble plat 5 sur le circuit imprimé 4.

Lors de l'assemblage du boîtier (figures 3A à 3C), le circuit imprimé étant supposé déjà en place dans le socle 1 du boîtier, l'extrémité du câble plat 5 est disposée sur la zone de contact 16 du circuit imprimé 4, et le câble plat 5 (préformé comme vu plus haut) est disposé autour de la saillie 9 du socle 1.

Puis le joint d'étanchéité 3 et le joint élastique 19, formée en un seul élément, sont disposés en place au dessus du rebord du socle 2 et au dessus de la zone de contact 16.

Enfin, le couvercle 2 du boîtier est vissé sur le socle 1 (par exemple par quatre vis disposées sensiblement aux angles du socle 1), venant ainsi, d'une part, comprimer l'extrémité du câble plat 5 sur la zone de contact 16 du circuit imprimé 4, et, d'autre part, serrer le câble plat 5 dans le moyen de blocage 6, et en particulier dans la zone de serrage 11.

La force de serrage du couvercle 2 sur le socle 1, est déterminée par le choix d'un vissage plus ou moins important et résulte en un pincement plus ou moins marqué des joints d'étanchéité 3 et élastique 19. Elle doit être suffisante pour éviter l'arrachement du câble plat 5 hors du boîtier lorsque une force de traction est exercée sur le câble plat 5 dans une direction horizontale vers l'extérieur du boîtier.

Par ailleurs, la pression exercée sur la zone de contact 16 doit être suffisante pour que les gaz restant entre le câble plat et le circuit imprimé soient expulsés hors de cette zone de contact 16, pour éviter une corrosion locale des conducteurs 21 du câble plat 5 ou des surfaces conductrices du circuit imprimé 4.

On considère que la force doit être d'environ 5 N sur chaque surface conductrice de la zone de contact 16 pour assurer un bon contact électrique et l'expulsion des gaz hors la zone de contact 16.

Dans ce cas, on constate que lors d'un effort de traction sur le câble plat 5 vers l'extérieur du boîtier, pratiquement aucun effort de traction n'est transmis à l'extrémité 15 du câble plat 5, et donc aucun effort n'est exercé sur la zone de contact 16. Une traction accrue sur le câble plat 5 provoque son déchirement hors de la zone de contact 16 (et typiquement hors du boîtier).

La forme du câble plat 5 dans le moyen de blocage 6, et son pincement par les joints d'étanchéité 3 et élastique 19 assurent bien l'immobilisation longitudinale du câble plat 5, qui est un corollaire nécessaire à la connexion par contact direct.

On comprend que dans l'invention, on tire avantage de la disposition du boîtier en deux parties 1, 2 séparés par un joint d'étanchéité 3 déformable, pour créer un moyen de pression réglable qui force le contact électrique direct entre la câble plat 5 et le circuit imprimé 4, et pour créer un passage en chicane pour la câble plat 5, réduisant ainsi la transmission d'un effort de traction sur la partie extérieure du câble plat 5 vers la zone de contact 16.

La portée de la présente invention ne se limite pas aux détails des formes de réalisation ci-dessus considérées à titre d'exemple, mais s'étend au contraire aux modifications à la portée de l'homme de l'art, et elle est déterminée par le tenue des revendications. En particulier, le contact n'est pas nécessairement réalisé à une extrémité du câble plat.

## Revendications

1. Boîtier électronique du type comportant un socle (1) et un couvercle (2), ledit boîtier étant adapté pour loger à son intérieur au moins un circuit imprimé (4) en connexion électrique avec un câble plat (5), traversant le boîtier et s'étendant à l'extérieur de celui-ci, ledit boîtier comportant un moyen (6) de blocage en translation du câble plat (5) et étant **caractérisé en ce qu'**il comporte des moyens (17, 19) de mise en pression d'une zone dénudée (15) du câble plat (5) sur une zone de contact (16) du circuit imprimé (4), et **en ce que** le blocage en translation et la connexion électrique sont réalisés de manière simultanée lors de l'emboîtement du couvercle (2) sur le socle (1)

2. Boîtier selon la revendication 1, **caractérisé en ce que** le moyen (6) de blocage en translation comporte un passage de câble en chicane (10 à 14) ménagé entre le socle (1) et le couvercle (2) du boîtier.

3. Boîtier selon la revendication 2, **caractérisé en ce que** le passage en chicane (10 à 14) comporte au moins une zone de serrage (11) sensiblement perpendiculaire à la direction principale du câble plat (5), et d'épaisseur sensiblement égale à l'épaisseur (7) dudit câble plat (5).

4. Boîtier selon l'une quelconque des revendications 1 à 3, **caractérisé en ce que** il comporte un joint d'étanchéité (3) à sa périphérie entre le socle (1) et le couvercle (2), et **en ce que** les moyens (17, 19) de mise en pression du câble plat (5) comportent un joint élastique (19) disposé au dessus du câble plat (5), et un renfort (17), disposé sous le circuit imprimé (4), au droit de la zone de contact (16).

5. Boîtier selon la revendication 4, **caractérisé en ce que** le joint d'étanchéité (3) et le joint élastique (19) sont formés d'un seul tenant.

6. Boîtier selon la revendication 5, **caractérisé en ce que** le socle (1) et le couvercle (2) du boîtier sont assemblés par vissage, avec un serrage adapté à créer une pression minimum prédéterminée sur la zone de contact (16) du circuit imprimé (4).

## Patentansprüche

1. Elektronikgehäuse mit einem Sockel (1) und einem Deckel (2), welches Gehäuse in der Lage ist, in seinem Inneren mindestens eine gedruckte Schaltung (4) in elektrischer Verbindung mit einem Flachkabel (5) aufzunehmen, das das Gehäuse durchquert und sich von diesem nach außen erstreckt, wobei das Gehäuse ein Mittel (6) zum Blockieren des Flachkabels (5) in Translationsrichtung aufweist und **dadurch gekennzeichnet ist, dass** es Mittel (17, 19) zum Unterdrucksetzen einer freigelegten Zone (15) des Flachkabels (5) auf einer Kontaktzone (16) der gedruckten Schaltung (4) aufweist, und dass die Blockierung in Translationsrichtung und die elektrische Verbindung beim Aufsetzen des Deckels (2) auf den Sockel (1) gleichzeitig hergestellt werden.

2. Elektronikgehäuse nach Anspruch 1, **dadurch gekennzeichnet, dass** das Mittel (6) zum Blockieren in Translationsrichtung einen gewundenen Kabeldurchgang (10 - 14) aufweist, der zwischen dem Sockel (1) und dem Deckel (2) des Gehäuses vorgesehen ist.

3. Elektronikgehäuse nach Anspruch 2, **dadurch gekennzeichnet, dass** der gewundene Durchgang (10 - 14) mindestens eine Einspannzone (11) aufweist, die im wesentlichen senkrecht zur Hauptrichtung des Flachkabels (5) liegt und eine Dicke hat, die im wesentlichen gleich der Dicke (7) des Flachkabels (5) ist.

4. Elektronikgehäuse nach einem der Ansprüche 1 bis 3, **dadurch gekennzeichnet, dass** es ein Dichtungsteil (3) an seinem Umfang zwischen dem Sockel (1) und dem Deckel (2) aufweist und dass die Mittel (17, 19) zum Unterdrucksetzen des Flachkabels (5) ein oberhalb des Flachkabels (5) angeordnetes elastisches Teil (19) und eine unterhalb der gedruckten Schaltung (4) angeordnete Versteifung (17) an der Stelle der Kontaktzone (16) aufweisen.

5. Elektronikgehäuse nach Anspruch 4, **dadurch gekennzeichnet, dass** das Dichtungsteil (3) und das elastische Teil (19) einstückig ausgebildet sind.

6. Elektronikgehäuse nach Anspruch 5, **dadurch gekennzeichnet, dass** der Sockel (1) und der Deckel (2) des Gehäuses durch eine Verschraubung zusammengesetzt sind, und zwar mit einer Einspannung, die in der Lage ist, einen vorgegebenen Mindestdruck auf die Kontaktzone (16) der gedruckten Schaltung (4) auszuüben.

## Claims

1. Electronic casing of the type comprising a base (1) and a lid (2), said casing being adapted to house within its interior at least one printed circuit (4) electrically connected to a flat cable (5) passing through the casing and extending outside thereof, said casing having a means (6) for preventing movement of the flat cable (5) and **characterised in that** it has means (17, 19) for pressing a stripped region (15) of the flat cable (5) against a contact zone (16) of the printed circuit (4), and **in that** the prevention of movement and the electrical connection are carried out simultaneously when the lid (2) is fitted over the base (1).

2. Casing according to Claim 1, **characterised in that** the means (6) for preventing movement has a cable passageway in the form of an S-shape (10 to 14) arranged between the base (1) and the lid (2) of the casing.

3. Casing according to Claim 2, **characterised in that** the S-shaped passageway (10 to 14) has at least one clamping zone (11) roughly perpendicular to the main direction of the flat cable (5), and with a thickness roughly equal to the thickness (7) of said flat cable (5).

4. Casing according to any one of Claims 1 to 3, **characterised in that** it has a gasket (3) at its periphery between the base (1) and the lid (2), and **in that** the means (17, 19) for depressing the flat cable (5) have an elastic seal (19) positioned above the flat cable (5) and a support (17), positioned below the printed circuit (4), in line with the contact zone (16).

5. Casing according to Claim 4, **characterised in that** the gasket (3) and the elastic seal (19) are formed of a single piece.

6. Casing according to Claim 5, **characterised in that** the base (1) and the lid (2) of the casing are screwed together sufficiently tightly to create a predetermined minimum pressure over the contact zone (16) of the printed circuit (4).
